# EUROPEAN PATENT APPLICATION

(11) **EP 4 495 996 A1**
(43) Date of publication of application: **22.01.2025**
(21) Application number: 24186040.2
(22) Date of filing: 02.07.2024
(51) Int. Cl.: H01L 25/065, H01L 23/498, H01L 23/538, H01L 25/18

(54) **THREE DIMENSIONAL CHIP ARCHITECTURE**

(30) Priority: 21.07.2023 US 202363514970 P; 14.06.2024 US 202418743518
(71) Applicant: Meta Platforms, Inc., Menlo Park, CA 94025 (US)
(72) Inventor: MADDURY, Mahesh Srinivasa, Menlo Park, 94025 (US); REDDY, Harikrishna Madadi, Menlo Park, 94025 (US); AGARWAL, Ravi Shankar, Menlo Park, 94025 (US)
(74) Representative: Murgitroyd & Company

(57) **Abstract**

Three-dimensional chip architecture is described herein. In one example aspect, an integrated circuit may include an interposer layer. The integrated circuit may further include a plurality of random access memory chiplets stacked atop the interposer layer, and a plurality of compute chiplets. The plurality of compute chiplets may be stacked atop a respective random access memory chip of the plurality of random access memory chiplets, such that the plurality of compute chiplets may be in electrical communication with the respective random access memory chip of the plurality of random access memory chiplets.

## Description

### TECHNOLOGICAL FIELD

The present disclosure relates generally to methods, apparatuses and computer program products for providing three-dimensional architecture for computer chips.

### BACKGROUND

For integrated circuits, electronic circuits may be fabricated on a semiconductor die, which may form a chip or chiplet. Each chip or chiplet may include one or more processing elements capable of performing specified functions on a given set of data or information.

Typically, the more processing elements a chip has, the more processing power the chip is capable of. However, conventional techniques to add processing power to a chip are limited. For example, in a two-dimensional approach, additional processing elements may be added along the width and length dimensions of the die. This two-dimensional approach is typically limited due to the size constraints (e.g., area) of a die, particularly for microelectronic technologies.

### SUMMARY

This summary is provided to introduce a selection of concepts in a simplified form that are further described below in the Detailed Description. This Summary is not intended to limit the scope of the claimed subject matter. The foregoing needs are met, to a great extent, by the present application described in more detail below.

Three-dimensional application specific integrated circuit architecture is described herein. An integrated circuit may include computing chiplets, which may be stacked atop random access memory chiplets. In some cases, the stacking may include a compute die stacked atop another compute die. The stacking may provide the ability for the computing chiplets and random access memory chiplets to communicate via short, low-latency, and/or low attenuation. The stacking may also allow for minimizing the area footprint of the integrated circuit.

In this regard, examples of the present disclosure may provide higher memory per unit area and increased compute processing (e.g., Tera operations per second (TOPs)) for integrated circuits. For instance, in some examples, the integrated circuit architecture of the examples of the present disclosure may increase the TOPS by at least four times (for example by utilizing a three-dimensional (3D) topology/configuration) and in some examples may increase memory (e.g., static random-access memory (SRAM)) capacity between eight - ten times. Additionally, the examples of the present disclosure may improve integrated circuit system latency and power efficiency between chiplets or chips. For example, by introducing another dimension as a degree of freedom, the communication networks in such an architecture may deliver lower latency than a conventional 2D topology.

According to a first aspect, there is provided an integrated circuit comprising: an interposer layer; a plurality of random access memory chiplets stacked atop the interposer layer; and a plurality of compute chiplets, wherein the plurality of compute chiplets are stacked atop a respective random access memory chip of the plurality of random access memory chiplets, such that the plurality of compute chiplets are in electrical communication with the respective random access memory chip of the plurality of random access memory chiplets.

The plurality of random access memory chiplets may comprise static random access memory (SRAM) chiplets.

The plurality of compute chiplets may comprise a plurality of processing elements (PEs).

The integrated circuit may further comprise a plurality of high bandwidth memory (HBM) chiplets stacked atop the interposer layer.

The integrated circuit may further comprise a set of chiplets stacked atop the interposer layer.

The plurality of random access memory chiplets may be configured to electrically communicate with one another via the interposer layer.

More than one compute chiplet of the plurality of compute chiplets may be stacked atop a random access memory chiplet of the plurality of random access memory chiplets.

One or more random access memory chiplets of the plurality of random access memory chiplets may be configured to electrically communicate with other random access memory chiplets of the plurality of random access memory chiplets via the interposer layer.

The integrated circuit may further comprise a substrate layer. The interposer layer may be stacked atop the substrate layer. The integrated circuit may further comprises at least one host central processing unit (CPU) stacked atop the substrate layer. The at least one host CPU may be in electrical communication with the interposer layer via the substrate layer.

The at least one host CPU may comprise two host CPUs.

The integrated circuit may further comprise a set of network and host central processing unit (CPU) chiplets. The set of network and host CPU chiplets may be stacked atop the interposer layer.

The integrated circuit may further comprise a host central processing unit (CPU) stacked atop the interposer layer.

The integrated circuit may further comprise: another random access memory stacked atop the interposer layer; and a host central processing unit (CPU) stacked atop the another random access memory. The host CPU may be in electrical communication with the another random access memory.

The another random access memory may be configured to electrically communicate with the plurality of random access memory chiplets via the interposer layer.

The integrated circuit may further comprise one or more double data rate (DDR) memory chiplets stacked atop the interposer layer.

The integrated circuit may be configured to perform artificial intelligence (Al) functions or machine learning (ML) functions.

According to a second aspect, there is provided a method comprising: transmitting at least one electrical signal from a computing chiplet; and transferring the at least one electrical signal to a random access memory chiplet, wherein the computing chiplet is stacked atop the random access memory chiplet, thereby forming a three-dimensional stacked integrated circuit.

The method may further comprise transmitting the at least one electrical signal from the random access memory chiplet to another component of the integrated circuit via an interposer layer of the integrated circuit.

The another component may be stacked on the interposer layer.

According to a third aspect, there is provided a computer-readable medium storing instructions that, when executed by the integrated circuit of the first aspect, cause the integrated circuit to carry out the method of the second aspect. The medium may be non-transitory.

There has thus been outlined, rather broadly, certain embodiments of the present disclosure in order that the detailed description thereof may be better understood, and in order that the present contribution to the art may be better appreciated.

Additional advantages will be set forth in part in the description which follows or may be learned by practice. The advantages will be realized and attained by means of the elements and combinations particularly pointed out in the appended claims. It is to be understood that both the foregoing general description and the following detailed description are exemplary and explanatory only and are not restrictive, as claimed.

### BRIEF DESCRIPTION OF THE DRAWINGS

In order to facilitate a more robust understanding of the application, reference is now made to the accompanying drawings, in which like elements are referenced with like numerals. These drawings should not be construed to limit the application and are intended only to be illustrative.
FIG. 1 depicts a conventional chip or chiplet.
FIG. 2 depicts a chip or chiplet implementing a three-dimensional architecture according to an example of the present disclosure.
FIG. 3 depicts a chip or chiplet implementing a three-dimensional architecture according to another example of the present disclosure.
FIG. 4 depicts a chip or chiplet implementing a three-dimensional architecture according to another example of the present disclosure.
FIG. 5 depicts a chip or chiplet implementing a three-dimensional architecture according to another example of the present disclosure.
FIG. 6 depicts a chip or chiplet implementing a three-dimensional architecture according to another example of the present disclosure.
FIG. 7 depicts a chip or chiplet implementing a three-dimensional architecture according to another example of the present disclosure.
FIG. 8 depicts a chip or chiplet implementing a three-dimensional architecture according to another example of the present disclosure.
FIG. 9 depicts a process according to an example of the present disclosure.
FIG. 10 depicts a device capable of implementing a chip or chiplet according to an example of the present disclosure.

### DETAILED DESCRIPTION

A detailed description of the illustrative examples will be discussed in reference to various figures, examples, and aspects herein. Although this description provides detailed examples of possible implementations, it should be understood that the details are intended to be examples and thus do not limit the scope of the application.

Reference in this specification to "one embodiment," "an embodiment," "one or more embodiments," "an aspect" or the like means that a particular feature, structure, or characteristic described in connection with the embodiment is included in at least one embodiment of the disclosure. Moreover, the term "embodiment" in various places in the specification is not necessarily referring to the same embodiment. That is, various features are described which may be exhibited by some embodiments and not by the other.

It is understood that any or all of the systems, methods and processes described herein may be embodied in the form of computer executable instructions, e.g., program code, stored on a computer-readable storage medium which instructions, when executed by a machine, such as a computer, server, transit device or the like, perform and/or implement the systems, methods and processes described herein. Specifically, any of the steps, operations or functions described above may be implemented in the form of such computer executable instructions. Computer readable storage media includes volatile and nonvolatile, removable, and non-removable media implemented in any method or technology for storage of information, but such computer readable storage media do not include signals. Computer readable storage media may include, but are not limited to, random access memory (RAM), read only memory (ROM), electrically erasable programmable read-only memory (EEPROM), flash memory or other memory technology, compact disc read only memory (CD ROM), digital versatile disks (DVD) or other optical disk storage, magnetic cassettes, magnetic tape, magnetic disk storage or other magnetic storage devices, or any other physical medium which may be used to store the desired information and which may be accessed by a computer.

As defined herein a "computer-readable storage medium," which refers to a non-transitory, physical or tangible storage medium (e.g., volatile or non-volatile memory device), may be differentiated from a "computer-readable transmission medium," which refers to an electromagnetic signal.

Some manufacturers may attempt to maximize processing and storage capabilities of an application specific integrated circuit (ASIC) by including more processing/storage components onto a given chip. There may also be a cost advantage as well, as smaller chip sizes may provide for more dies to be cut or etched from a single wafer. However, ASIC dimensions are typically limited based on the reticle limit, which is the maximum area of chip that may be manufactured. Manufacturers may be unable to overcome the reticle limit by increasing the width and/or length dimensions of the chip. These large full reticle size chips may be prone to defects. This may result in poor yield and increasing chip cost. However, these issues may be addressed by using smaller chip size in particular technologies (e.g., microelectronics).According to the present disclosure, a chip may include a three-dimensional architecture. The chip may include computing chiplets configured to perform various processing functions. The computing chiplets may be stacked atop random access memory chiplets. Likewise, other components of the chip may either be stacked on an interposer, or may be stacked on memory as well, to enable communicating between non-stacked entities. This stacking may facilitate high speed, low latency communications between the memory and computing chiplets, which may enable for more powerful processing capabilities of the chip.

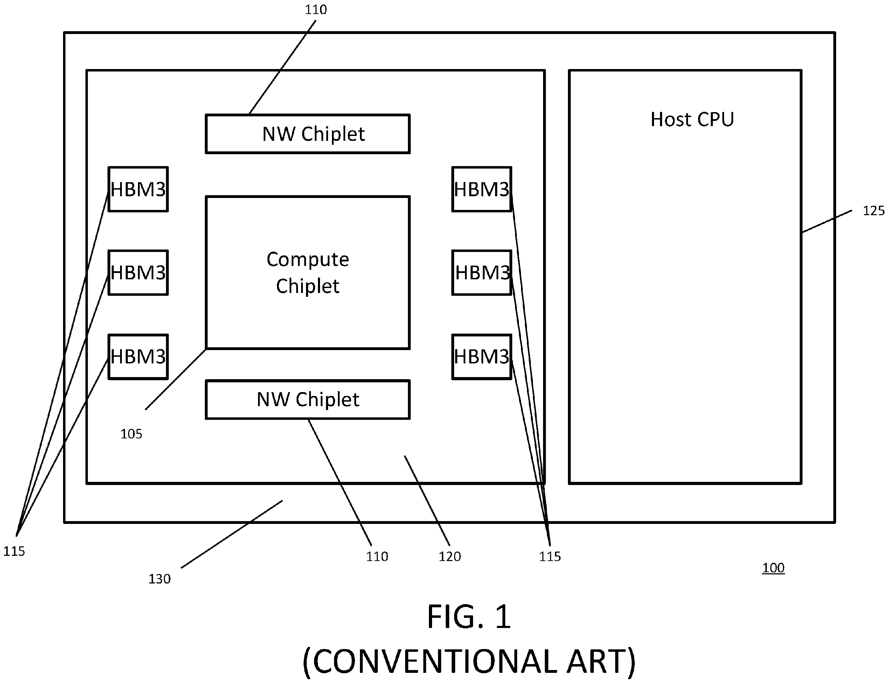

FIG. 1 depicts a conventional chip 100. The chip 100 may include a compute chiplet 105 capable of performing various processes; network (NW) chiplets 110 capable of managing communications between entities internal and external to the chip 100; and high bandwidth memory (HBM) chiplets 115 configured to store data (e.g., as bits). These components may be placed on an interposer 120. The interposer 120 may facilitate electrical communications between the various components atop the interposer 120. This configuration of various components in electrical communication with each other via an interposer is typically referred to as a 2.5-dimensional configuration (2.5D).

Chips including 2.5D configurations are typically limited in capabilities, in part due to the communication routes imposed by the configuration. Each component positioned on the interposer may transmit communications to other components on the interposer via the interposer. The communication route length and material of the interposer may cause communication delay as well as communication attenuation. This lag may also impose limitations on processing capabilities of the chip, particularly in examples where multiple components may require communicating or coordinating with one another to fulfill a task.

Further, in examples where the chip 100 is also an integrated circuit, a host CPU 125 may also be included in the chip 100. However, host CPUs 125 are typically unable to be placed atop the interposer 120, and thus an additional substrate layer 130 (e.g., a printed circuit board (PCB) layer) may be implemented, where the host CPU 125 and the interposer 120 are placed atop the substrate layer 130. This may further cause communication delays, as the host CPU 125 communicates with the components of the interposer 120 by transmitting a communication to the substrate layer 130, which travels to the interposer 120, and then to the particular component (e.g., the compute chiplet 105).

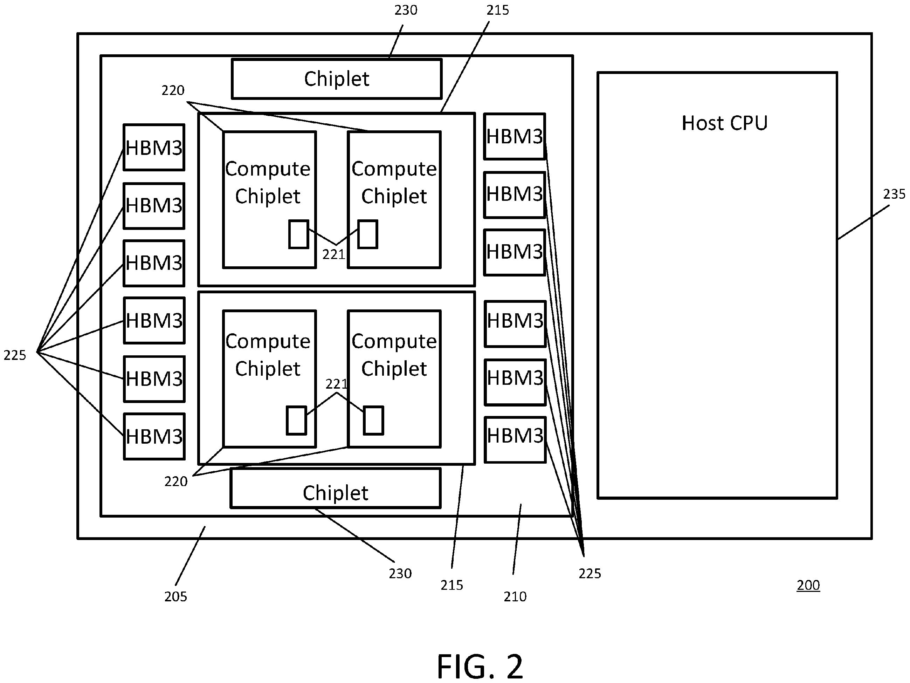

FIG. 2 depicts a chip 200 implementing a 3D configuration according to an example of the present disclosure. The chip 200 may in some examples be a chiplet that may be configured to operate with other chiplets (not shown) to form a chip. In some examples, the chip 200 may be an ASIC. In some examples, the chip 200 may be configured to perform machine learning (ML) processes and/or artificial intelligence (Al) processes. In some other examples, the chip 200 may be configured to perform other applications (e.g., video transcoding, etc.).

The chip 200 may include a substrate 205. The substrate 205 may be a section of semiconducting material (e.g., layer) that may support other components of the chip 200. For example, the substrate 205 may be composed of silicon. The substrate 205 may form a plane, where the substrate 205 may include a length and width that are substantially greater than a substrate thickness. The substrate 205 may be configured to house, include, or contain a circuitry component(s) along a given surface.

The chip 200 may also include an interposer 210. The interposer 210 may be disposed atop the substrate 205. The interposer 210 may facilitate electrical communications from the substrate 205 to components atop the interposer 210, or between different components atop the interposer 210. The interposer 210 may be composed of semiconducting material, such as for example silicon, and may include electrical connections (e.g., on a top surface) capable of carrying electrical connections to and from different components atop the interposer 210. The interposer 210 may form a plane, where the interposer 210 may include a width and length that are substantially greater than an interposer thickness. Further, the interposer plane may be generally parallel to the substrate plane. In some examples, the interposer length, width, or both, may be smaller than the length and/or the respective width of the substrate 205.

One or more bottom chiplets (e.g., random access memory chiplets 215) may be disposed atop the interposer 210. The random access memory chiplets 215 may be electrically connected to the interposer 210 (e.g., via the interposer top surface and the memory bottom surface), such that a random access memory chiplet 215 is configured to transmit and receive electrical communications via the interposer 210 to other components atop the interposer 210, to other components atop the substrate 205, or both. The random access memory chiplets 215 may in some examples be static random access memory (SRAM), such that the data stored by a SRAM is statically maintained. In some cases, the random access memory chiplets 215 may connect to DRAM, and may include In-memory compute, near memory, Network-On-Chip, and/or the like.

The chip 200 may also include one or more computing chiplets 220. Computing chiplets 220 may be disposed atop a random access memory chiplet 215. A computing chiplet 220 may be in electrical communication with the random access memory chiplet 215 the computing chiplet is disposed on. For example, a computing chiplet 220 may include electrical connections on its bottom surface, which may be coupled to electrical connection on a top surface of the respective random access memory chiplet 215. Thus, a computing chiplet 220 may be configured to be in electrical communication with its respective random access memory chiplet 215. In some examples, a computing chiplet 220 may be configured to electrically communicate with other components atop the interposer 210, such as other computing chiplets 220 (e.g., an electrical communication travels from the computing chiplet 220, to its respective random access memory chiplet 215, to the interposer 210, to another random access memory chiplet 215, and to another computing chiplet 220), other components atop the substrate 205 (e.g., a CPU), and/or the like. In some examples, the electrical connection between the computing chiplet 220 and the respective random access memory chiplet 215 may be direct, such as by bump bonds or electrical pins. In some examples, the electrical connection may be indirect, such as by implementing electrical leads between a computing chiplet 220 and a respective random access memory chiplet 215.

Each computing chiplet 220 may be configured to include one or more processing elements 221. The processing elements 221 may be configured to receive a data set(s) and perform distinct process operations on the data(s). For example, a processing element 221 may be configured to perform an arithmetic function (e.g., multiplier, derivation, additive, and/or the like) on the set of data(s). In some examples, a processing element 221 may be configured to perform a logical function (e.g., and, ors, nors, and/or the like) on a set of data(s). In some examples, the processing elements 221 may include functions specific to that processing element (e.g., the processing elements may be distinct from one another). In some examples, the processing elements 221 may receive the data set(s) from a particular circuitry component (e.g., another processing element), process the data, and output the processed results to another particular circuitry component (e.g., another particular circuitry element) to form a processing pipeline. In some examples, a computing chiplet 220 may include a predetermined quantity of processing elements 221 (e.g., 32 processing elements, 16 processing elements, etc.).

More than one computing chiplet 220 may be stacked atop a given random access memory chiplet 215. For example, as shown in FIG. 2, a random access memory chiplet 215 may include two or more computing chiplets 220 stacked atop the random access memory chiplet 215. In some examples, each computing chiplet 220 on a respective random access memory chiplet 215 may electrically communicate with another computing chiplet 220 on the respective random access memory chiplet 215 directly via the random access memory chiplet 215, such that the electrical communication may not travel through the interposer 210.

The chip 200 may also include one or more high bandwidth memory (HBM) chiplets 225. In some examples of the present disclosure, the HBM chiplets 225 may be referred to herein as HBMs 225. The HBMs 225 may provide additional memory capacity of the chip 200, for example, for Al model/inference training, and/or the like. The HBMs 225 may be disposed on the interposer 210. For example, the HBMs 225 may be in direct contact with the interposer 210, such that a bottom surface of the HBMs 225 may contact a top surface of the interposer 210. The HBMs 225 may be in electrical communication with the interposer 210. For example, the bottom surface of an HBM 225 may include electrical connections that may couple to respective electrical connections of the top surface of the interposer 210. In some examples, the electrical connections may include bump bonds, electrical pins, and/or the like. The HBMs 225 may in some examples include second generation of high bandwidth memory (HBM2), second generation evolutionary high bandwidth memory (HBM2E), third generation of high bandwidth memory (HBM3), fourth generation of high bandwidth memory (HBM4), HBM with processing-in-memory, and/or the like.

The chip 200 may also include one or more chiplets 230. The chiplets 230 may for example include functionality, including but not limited to, networking, input/output (I/O), a network interface card or a network interface controller (NIC) and/or the like. The chiplets 230 may be disposed on the interposer 210. For example, the chiplets 230 may be in direct contact with the interposer 210, such that a bottom surface of the chiplets 230 may contact a top surface of the interposer 210. The chiplets 230 may be in electrical communication with the interposer 210. For example, the bottom surface of a chiplet 230 may include electrical connections that may couple to respective electrical connections of the top surface of the interposer 210. In some examples, the electrical connections may include bump bonds, electrical pins, and/or the like. The chiplets 230 may be configured to facilitate communications between the various components of the chip 200. For example, in some examples the chiplets 230 may include network-on-chip logic. For example, the chiplets 230 may manage processing pipelines of processing elements either within or between computer chiplets 220. In some examples, the chiplets 230 may be configured to facilitate communications between the chip 200 and external components.

The chip may also include one or more host CPUs 235. The host CPUs 235 may be disposed on the substrate 205. For example, the host CPUs 235 may be in direct contact with the substrate 205, such that a bottom surface of the host CPUs 235 may contact a top surface of the substrate. The host CPUs 235 may be in electrical communication with the substrate 205. For example, the bottom surface of a host CPU(s) 235 may include electrical connections that may couple to respective electrical connections of the top surface of the substrate 205. In some examples, the electrical connections may include bump bonds, electrical pins, and/or the like. The host CPUs 235 may include logic to manage the various other components of the chip 200. For example, the host CPUs 235 may be configured to execute artificial intelligence, machine learning, video processing, and/or the like.

The chip 200 may utilize 3D architecture, at least with respect to the computing chiplets 220 being stacked atop the random access memory chiplets 215, and likewise the random access memory chiplets 215 being stacked atop the interposer 210. The stacking of the computing chiplets 220 atop the random access memory chiplets 215 may allow for very low latency for communications between the computing chiplets 220 atop the random access memory chiplets 215, which may enhance the processing capabilities of the chip 200. Further, the implementation of various components on the interposer 210 (e.g., in a 2.5D architecture) may further enhance low latency across the chip 200. For example, components may include an embedded silicon bridge, embedded metal connectors, passives, capacitors, chiplet-to-chiplet physical layer, and/or the like.

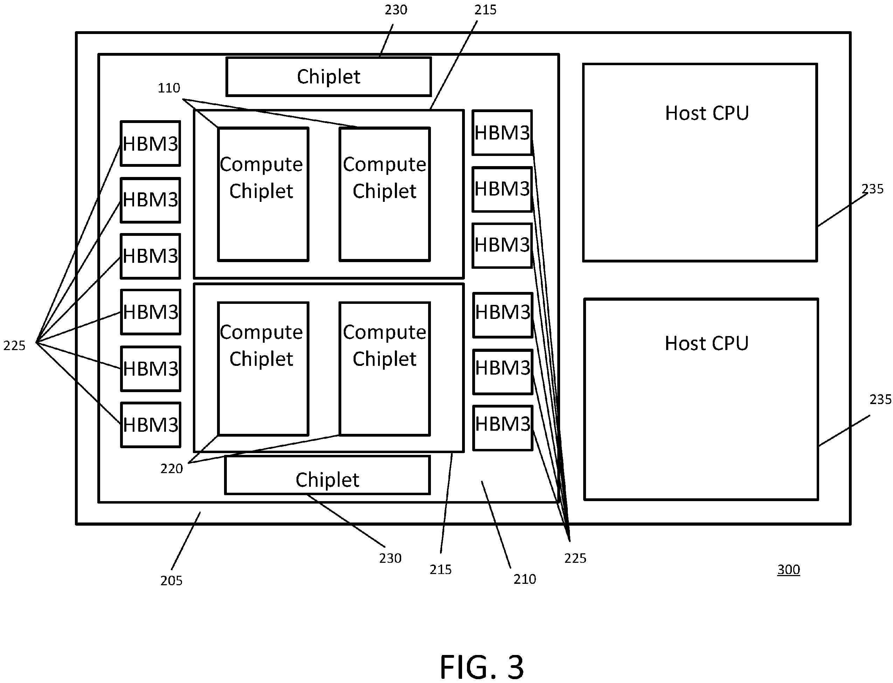

FIGS. 3, 4, 5, 6, 7, and 8 depict various other examples of a chip implementing 3D architecture according to the present disclosure. For example, FIG. 3 depicts a chip with a similar 3D configuration as the chip 200 of FIG. 2, albeit with two host CPUs 235 positioned on the substrate 205. Each host CPU 235 may be in electrical communication with the other entities of the chip 300 (e.g., via the substrate 205). Thus, the host CPUs 235 may either share logic instructions (e.g., for a same program/application), or the host CPUs 235 may be distinct from one another (e.g., hosting different programs/applications for execution).

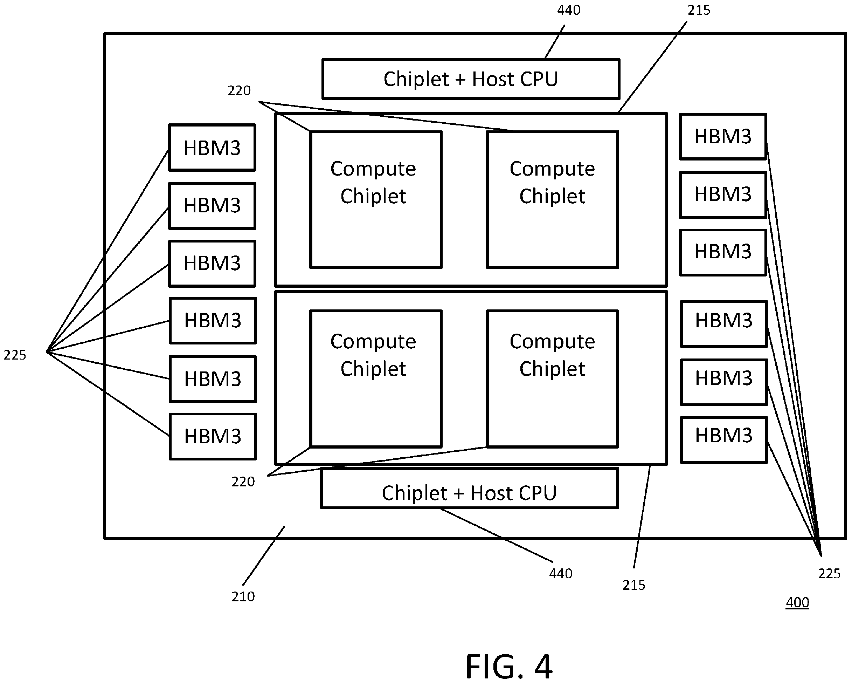

FIG. 4 depicts a chip 400 implementing a 3D architecture according to an example of the present disclosure. The chip 400 may have a similar 3D configuration as the chip 200 and chip 300 depicts in FIGS. 2 and 3, respectively. The chip 400 includes network and host CPUs 440. The chiplet and host CPUs 440 may be a combination of hardware and logic that is included in chiplets 230 and host CPUs 235 as described with reference to FIGS. 2 and 3. The chiplet and host CPUs 440 may manage or facilitate communications between various entities of the chip 400 (e.g., managing processing pipelines within and between compute chiplets 220), as well as communications between the chip 400 and external entities. The chiplet and host CPUs 440 may also include host processing logic (e.g., an executable program(s)/application(s)), and may instruct or manage the other entities of the chip 400 in executing the logic. The chiplet and host CPUs 440 may be positioned at the interposer 210, and may be in electrical communication with the interposer 210. Thus, the chiplet and host CPUs 440 may be in electrical communication with other entities of the chip 400 via the interposer 210.

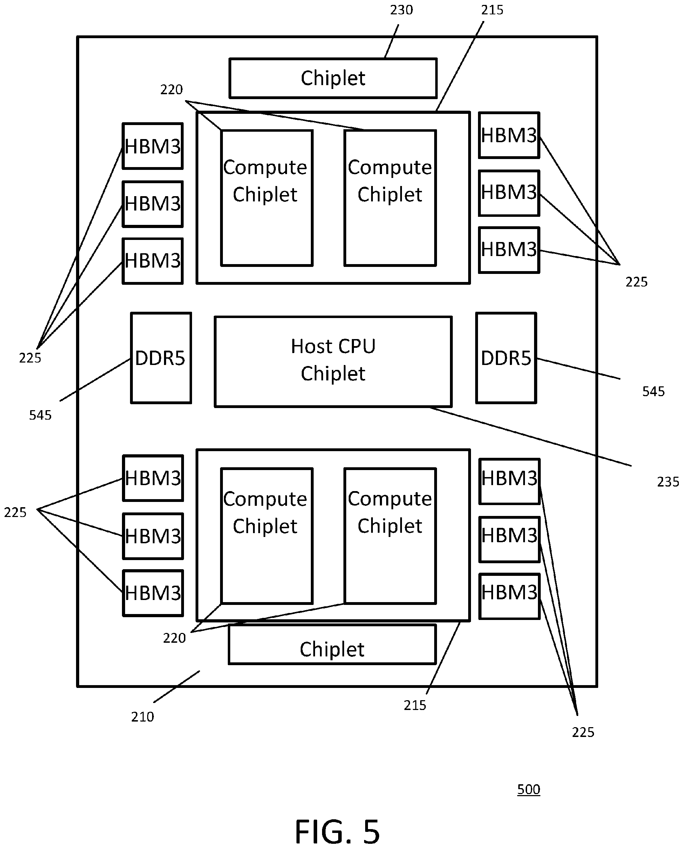

FIG. 5 depicts a chip 500 implementing a 3D architecture according to an example of the present disclosure. The chip 500 may have a similar configuration as chip 200 as described with reference to FIG. 2. However, the chip 500 may include a host CPU chiplet 235 (also referred to herein as host CPU 235) positioned on the interposer 210, in lieu of a substrate layer as depicted in FIG. 2. The host CPU 235 may be in electrical communication with the interposer 210, such that the host CPU 235 may communicate with other entities of the chip 500 via the interposer 210. The chip 500 may also include double data rate (DDR) memory 545. The DDR memory 545 may be positioned atop the interposer 210 such that the DDR memory 545 is in electrical communication with the interposer 210. The DDR memory 545 may be configured to electrically communicate with other entities of the chip 500, such as for example the host CPU 235. The DDR memory 545 may include volatile memory that may be configured to fetch data based on memory clock signals. In some examples, the DDR memory 545 may include Double Data Rate 2 (DDR2) memory, Double Data Rate 3 (DDR3) memory, Double Data Rate 4 (DDR4) memory, Double Data Rate 5 (DDR5) memory, Low-Power Double Data Rate (LPDDR), and/or the like. The DDR memory 545 may facilitate overall system memory of the chip 500.

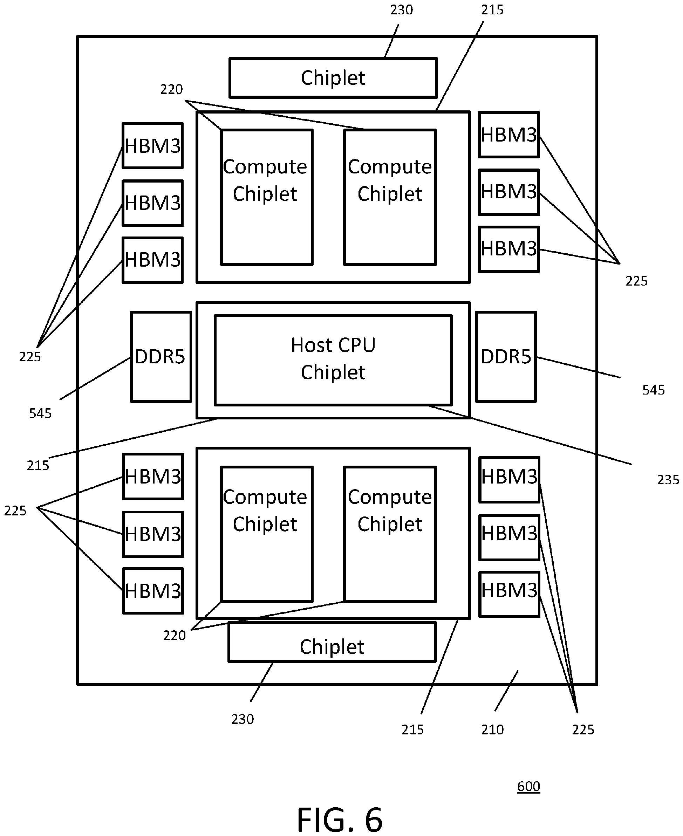

FIG. 6 depicts a chip 600 implementing a 3D architecture according to an example of the present disclosure. The chip 600 may have a configuration similar to the chip 500 as described with reference to FIG. 5. However, the chip 600 may also include a host CPU 235 disposed atop a random access memory chiplet 215. The host CPU 235 may be in electrical communication with the respective random access memory chiplet 215 (e.g., via a bottom surface of the host CPU 235 and a top surface of the random access memory chiplet 215), and likewise the random access memory chiplet 215 may be in electrical communication with the interposer 210 (e.g., via a bottom surface of the random access memory chiplet 215 and a top surface of the interposer 210). The host CPU 235 may thus be configured for electrical communication with other entities of the chip 600 (e.g., an electrical signal may be sent from the host CPU 235, to the random access memory chiplet 215, to the interposer 210, and then to another entity of the chip 600).

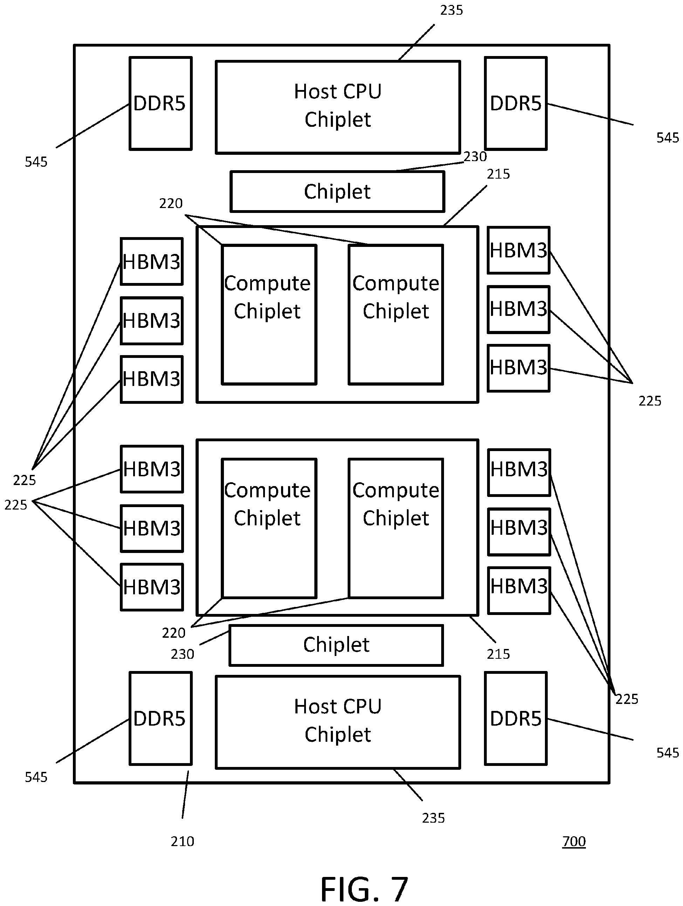

FIG. 7 depicts a chip 700 implementing a 3D architecture according to an example of the present disclosure. The chip 700 may have a configuration similar to chip 500 as described with reference to FIG. 5. The chip may include two (or more) host CPUs 235 positioned on the interposer 210. Each host CPU 235 may be electrical communication with the other entities of the chip 700 (e.g., via the interposer 210). Thus, the host CPUs 235 may either share logic instructions (e.g., for a same program), or they may be distinct from one another (e.g., hosting different programs for execution).

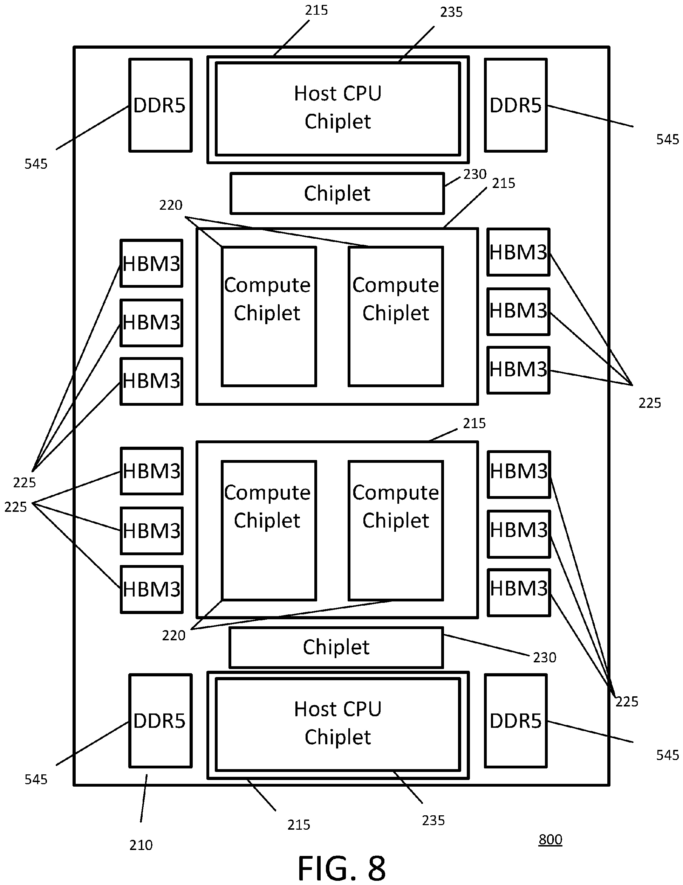

FIG. 8 depicts a chip 800 implementing a 3D architecture according to an example of the present disclosure. The chip 800 may have a configuration similar to chip 700 as described with reference to FIG. 7. The chip 800 may also include host CPUs 235 disposed atop respective random access memory chiplets 215. The host CPUs 235 may be in electrical communication with the respective random access memory chiplet 215 (e.g., via a bottom surface of the host CPU 235 and a top surface of the random access memory chiplet 215), and likewise the random access memory chiplet 215 may be in electrical communication with the interposer 210 (e.g., via a bottom surface of the random access memory chiplet 215 and a top surface of the interposer 210). The host CPU 235 may thus be configured for electrical communication with other entities of the chip 800 (e.g., an electrical signal may be sent from the host CPU 235, to the random access memory chiplet 215, to the interposer 210, and then to another entity of the chip 800). Thus, the host CPUs 235 may either share logic instructions (e.g., for a same program/application), or they may be distinct from one another (e.g., hosting different programs/applications for execution).

While the chips described with reference to FIGS. 2, 3, 4, 5, 6, 7, and 8 provide particular examples, the disclosure provided herein is not limited to these examples. For example, while FIGS. 2, 3, 4, 5, 6, 7, and 8 depict various numbers of chip components, in other examples a chip may include less or more of those components implementing the architecture described herein. For example, considering FIG. 2, the chip 200 may include less or more than the HBM3 chiplets 225 than the 12 HBM3 chiplets 225 depicted. The 3D stacking architecture may enable integration of different functionalities (e.g., cryptography, security input/output (IO), and/or the like) while achieving higher performance. The 3D stacking architecture may also increase memory and/or processing capacity for a chip. Additionally, in some examples, the various chip components of the chip may include different locations compared to those shown in FIGS. 2, 3, 4, 5, 6, 7, and 8.

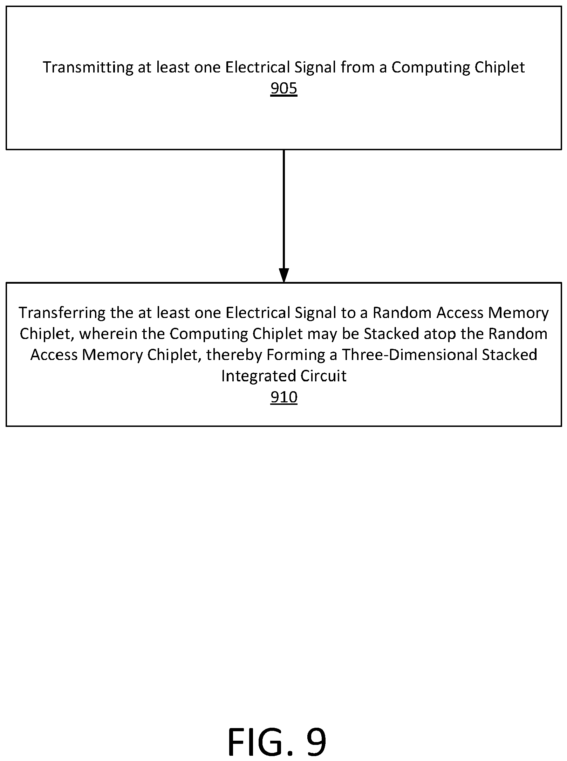

FIG. 9 depicts a process 900 according to an example of the present disclosure. The process 900 may be implemented by a chip, such as for example chip 200, chip 300, chip 400, chip 500, chip 600, chip 700, chip 800 of FIGS. 2-8, respectively. At Step 905, at least one electrical signal from a computing chiplet (e.g., computing chiplet 220) may be transmitted. At Step 910, the at least one electrical signal may be transferred or transmitted from the computing chiplet to a random access memory chiplet (e.g., random access memory chiplet 215), where the computing chiplet may be stacked atop the random access memory chiplet, thereby forming a three-dimensional stacked integrated circuit. In some examples, a bottom surface of the computing chiplet may contact a top surface of the random access memory chiplet. In some examples, the bottom surface of the computing chiplet may include electrical connections that couple to respective electrical connections on the top surface of the random access memory chiplet. In some examples, three-dimensional stacking may include placing the computing chiplet atop the random access memory chiplet, or vice versa, such that the width/length dimensions of the computing chiplet may be configured/run parallel to the width/length dimensions of the random access memory chiplet. In some other examples, the at least one electrical signal may be transferred or transmitted from the random access memory to another component of the integrated circuit via an interposer layer. For example, a bottom surface of the random access memory chiplet may include electrical connections that couple to respective electrical connections of a top surface of the interposer layer. In some examples, the another component may be stacked on the interposer layer. In some examples, the another component of the integrated circuit may be referred to herein as a second component of the integrated circuit. In some examples, the another component may include another random access memory chiplet, a host CPU, a networking chiplet, or a high bandwidth memory chiplet. In some examples, the another random access memory chiplet may be referred to herein as a second random access memory chiplet.

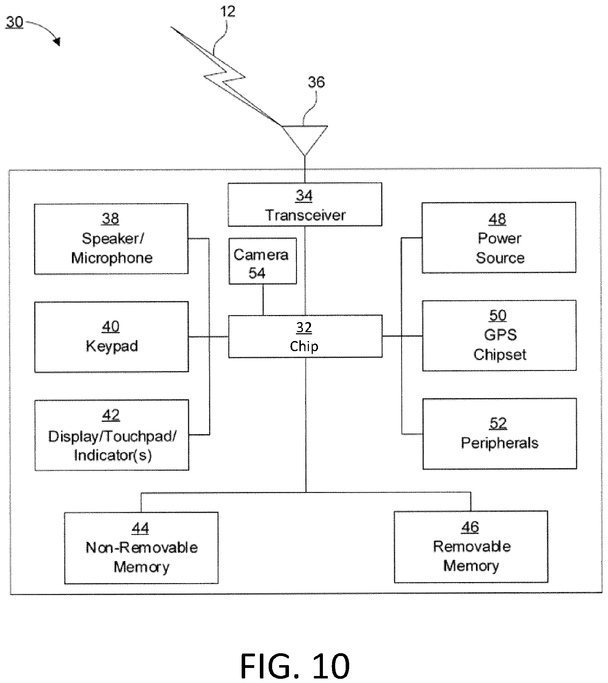

FIG. 10 is a block diagram of an exemplary computing device 30 which may incorporate a chip described herein, such as chip 200, chip 300, chip 400, chip 500, chip 600, chip 700, chip 800 of FIGS. 2, 3, 4, 5, 6, 7, and 8 respectively. In an example, the computing device 30 may be a server or communication device configured to provide AI functions and/or ML functions.

As shown in FIG. 10, the computing device 30 may include a chip 32, non-removable memory 44, removable memory 46, a speaker/microphone 38, a keypad 40, a camera 54, a display/touchpad/indicators 42, a power source 48, a global positioning system (GPS) chipset 50, and other peripherals 52. The computing device 30 may also include communication circuitry, such as a transceiver 34 and a transmit/receive element 36. It will be appreciated the computing device 30 may include any sub-combination of the foregoing elements while remaining consistent with an example.

The chip 32 may be an integrated circuit, and in particular, for example, an ASIC. The chip 32 may be an example of chip 200, chip 300, chip 400, chip 500, chip 600, chip 700, chip 800 of FIGS. 2, 3, 4, 5, 6, 7, and 8. The chip 32 may be capable of various functions designed for the computing device 30. For example, the chip 32 may be configured to perform AI training and/or ML training, to process output from a AI/ML model, inference and video processing, and/or the like. In other examples, the chip 32 may perform other functions or tasks.

In some examples, the chip 32 may execute computer-executable instructions stored in the memory (e.g., memory 44 and/or memory 46) of the computing device 30 in order to perform the various required functions of the computing device 30. For example, the chip 32 may perform signal coding, data processing, power control, input/output processing, and/or any other functionality that enables the computing device 30 to operate in a wireless or wired environment. In some examples, the chip 32 may run application-layer programs (e.g., browsers) and/or radio access-layer (RAN) programs and/or other communications programs. In some examples, the chip 32 may also perform security operations such as authentication, security key agreement, and/or cryptographic operations, such as at the access-layer and/or application layer for example.

The chip 32 may be coupled to communication circuitry (e.g., transceiver 34 and transmit/receive element 36). In some examples, the chip 32, through the execution of computer executable instructions, may control the communication circuitry in order to cause the computing device 30 to communicate with other computing devices via the network to which it is connected.

The transmit/receive element 36 may be configured to transmit signals to, or receive signals from, other computing devices or networking equipment. For example, the transmit/receive element 36 may be an antenna configured to transmit and/or receive radio frequency (RF) signals. The transmit/receive element 36 may support various networks and air interfaces, such as wireless local area network (WLAN), wireless personal area network (WPAN), cellular, and the like. In yet another example, the transmit/receive element 36 may be configured to transmit and receive both RF and light signals. It will be appreciated that the transmit/receive element 36 may be configured to transmit and/or receive any combination of wireless or wired signals.

The transceiver 34 may be configured to modulate the signals that are to be transmitted by the transmit/receive element 36 and to demodulate the signals that are received by the transmit/receive element 36. As noted above, the computing device 30 may have multi-mode capabilities. Thus, the transceiver 34 may include multiple transceivers for enabling the computing device 30 to communicate via multiple radio access technologies (RATs), such as universal terrestrial radio access (UTRA) and Institute of Electrical and Electronics Engineers (IEEE 802.11), for example.

The chip 32 may access information from, and store data in, any type of suitable memory, such as the non-removable memory 44 and/or the removable memory 46. For example, the chip 32 may store session context in its memory, as described above. The non-removable memory 44 may include RAM, ROM, a hard disk, or any other type of memory storage device. The removable memory 46 may include a subscriber identity module (SIM) card, a memory stick, a secure digital (SD) memory card, and the like. In other examples, the chip 32 may access information from, and store data in, memory that is not physically located on the computing device 30, such as on a server or a home computer.

The chip 32 may receive power from the power source 48 and may be configured to distribute and/or control the power to the other components in the computing device 30. The power source 48 may be any suitable device for powering the computing device 30. For example, the power source 48 may include one or more dry cell batteries (e.g., nickelcadmium (NiCd), nickel-zinc (NiZn), nickel metal hydride (NiMH), lithium-ion (Li-ion), etc.), solar cells, fuel cells, and the like.

The chip 32 may also be coupled to the GPS chipset 50, which may be configured to provide location information (e.g., longitude and latitude) regarding the current location of the computing device 30. It will be appreciated that the computing device 30 may acquire location information by way of any suitable location-determination method while remaining consistent with an example.

The foregoing description of the exemplary aspects of the present disclosure has been presented for the purpose of illustration. It is not intended to be exhaustive or to limit the patent rights to the precise forms disclosed. Persons skilled in the relevant art may appreciate that many modifications and variations are possible in light of the above disclosure.

Some portions of this description describe the exemplary aspects of the present disclosure in terms of applications and/or symbolic representations of operations on information. These application descriptions and representations are commonly used by those skilled in the data processing arts to convey the substance of their work effectively to others skilled in the art. These operations, while described functionally, computationally, or logically, are understood to be implemented by computer programs or equivalent electrical circuits, microcode, or the like. Furthermore, it has also proven convenient at times, to refer to these arrangements of operations as components, without loss of generality. The described operations and their associated components may be embodied in software, firmware, hardware, or any combinations thereof.

Any of the steps, operations, or processes described herein may be performed or implemented with one or more hardware or software components, alone or in combination with other devices. In one exemplary aspect of the present disclosure, a software component may be implemented with a computer program product comprising a computer-readable medium containing computer program code, which may be executed by a computer processor for performing any or all of the steps, operations, or processes described.

Some exemplary aspects of the present disclosure also may relate to an apparatus for performing the operations herein. This apparatus may be specially constructed for the required purposes, or it may comprise a computing device selectively activated or reconfigured by a computer program stored in the computer. Such a computer program may be stored in a non-transitory, tangible computer readable storage medium, or any type of media suitable for storing electronic instructions, which may be coupled to a computer system bus. Furthermore, any computing systems referred to in the specification may include a single processor or may be architectures employing multiple processor designs for increased computing capability.

Some exemplary aspects of the present disclosure also may relate to a product that is produced by a computing process described herein. Such a product may comprise information resulting from a computing process, where the information is stored on a non-transitory, tangible computer readable storage medium and may include any example aspect of a computer program product or other data combination described herein.

The language used in the specification has been principally selected for readability and instructional purposes, and it may not have been selected to delineate or circumscribe the inventive subject matter. It is therefore intended that the scope of the patent rights be limited not by this detailed description, but rather by any claims that issue on an application based hereon. Accordingly, the disclosure of the exemplary aspects is intended to be illustrative, but not limiting, of the scope of the patent rights, which is set forth in the following claims.

## Claims

1. An integrated circuit comprising:
an interposer layer;
a plurality of random access memory chiplets stacked atop the interposer layer; and
a plurality of compute chiplets, wherein the plurality of compute chiplets are stacked atop a respective random access memory chip of the plurality of random access memory chiplets, such that the plurality of compute chiplets are in electrical communication with the respective random access memory chip of the plurality of random access memory chiplets.

2. The integrated circuit of claim 1, wherein the plurality of random access memory chiplets comprise static random access memory (SRAM) chiplets.

3. The integrated circuit of claim 1 or 2, wherein the plurality of compute chiplets comprise a plurality of processing elements (PEs).

4. The integrated circuit of any preceding claim, further comprising:
a plurality of high bandwidth memory (HBM) chiplets stacked atop the interposer layer; and/or
a set of chiplets stacked atop the interposer layer.

5. The integrated circuit of any preceding claim, wherein the plurality of random access memory chiplets are configured to electrically communicate with one another via the interposer layer.

6. The integrated circuit of any preceding claim, wherein more than one compute chiplet of the plurality of compute chiplets are stacked atop a random access memory chiplet of the plurality of random access memory chiplets.

7. The integrated circuit of any preceding claim, wherein one or more random access memory chiplets of the plurality of random access memory chiplets are configured to electrically communicate with other random access memory chiplets of the plurality of random access memory chiplets via the interposer layer.

8. The integrated circuit of any preceding claim, further comprising:
a substrate layer, wherein the interposer layer is stacked atop the substrate layer; and
at least one host central processing unit (CPU) stacked atop the substrate layer, wherein the at least one host CPU is in electrical communication with the interposer layer via the substrate layer;
preferably wherein the at least one host CPU comprises two host CPUs.

9. The integrated circuit of any preceding claim, further comprising:
a set of network and host central processing unit (CPU) chiplets, wherein the set of network and host CPU chiplets are stacked atop the interposer layer; and/or
a host central processing unit (CPU) stacked atop the interposer layer.

10. The integrated circuit of any preceding claim, further comprising:
another random access memory stacked atop the interposer layer; and
a host central processing unit (CPU) stacked atop the another random access memory, wherein the host CPU is in electrical communication with the another random access memory;
preferably wherein the another random access memory is configured to electrically communicate with the plurality of random access memory chiplets via the interposer layer.

11. The integrated circuit of any preceding claim, further comprising:
one or more double data rate (DDR) memory chiplets stacked atop the interposer layer.

12. The integrated circuit of any preceding claim, wherein the integrated circuit is configured to perform artificial intelligence (Al) functions or machine learning (ML) functions.

13. A method comprising:
transmitting at least one electrical signal from a computing chiplet; and
transferring the at least one electrical signal to a random access memory chiplet, wherein the computing chiplet is stacked atop the random access memory chiplet, thereby forming a three-dimensional stacked integrated circuit.

14. The method of claim 13, further comprising:
transmitting the at least one electrical signal from the random access memory chiplet to another component of the integrated circuit via an interposer layer of the integrated circuit; preferably wherein the another component is stacked on the interposer layer.

15. A computer-readable medium storing instructions that, when executed by the integrated circuit of any of claims 1 to 12, cause the processor to carry out the method of claim 13 or 14.
